(19) Europäisches Patentamt
European Patent Office
Office européen des brevets

(11) **EP 3 828 564 B1**

## (12) EUROPÄISCHE PATENTSCHRIFT

(45) Veröffentlichungstag und Bekanntmachung des Hinweises auf die Patenterteilung:
**08.06.2022 Patentblatt 2022/23**

(51) Internationale Patentklassifikation (IPC):
**G01R 31/34** *(2020.01)* **G01R 19/00** *(2006.01)*
**G01R 29/16** *(2006.01)*

(21) Anmeldenummer: **20210210.9**

(22) Anmeldetag: **27.11.2020**

(52) Gemeinsame Patentklassifikation (CPC):
**G01R 31/34;** G01R 19/0092; G01R 29/16

(54) **VALIDIERUNG VON PHASENSTRÖMEN EINES MEHRPHASENSYSTEMS**

VALIDATION OF PHASE CURRENTS OF A MULTI-PHASE SYSTEM

VALIDATION DES COURANTS DE PHASE D'UN SYSTÈME MULTI-PHASE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.11.2019 AT 510442019**

(43) Veröffentlichungstag der Anmeldung:
**02.06.2021 Patentblatt 2021/22**

(73) Patentinhaber: **B&R Industrial Automation GmbH 5142 Eggelsberg (AT)**

(72) Erfinder: **Mayrhofer, Andreas 5142 Eggelsberg (AT)**

(74) Vertreter: **Patentanwälte Pinter & Weiss OG Prinz-Eugen-Straße 70 1040 Wien (AT)**

(56) Entgegenhaltungen:
US-A- 5 357 181    US-A- 6 005 393
US-A1- 2014 266 111    US-A1- 2018 358 888

## Beschreibung

Die gegenständliche Erfindung betrifft ein Verfahren zum sicheren Betrieb eines Mehrphasensystems, wobei in einer Mehrzahl von Phasen des Mehrphasensystems jeweils ein Phasenstrom fließt und wobei für eine Validierung der Phasenströme von Phasenstromsensoren Strommesswerte der Phasenströme erfasst werden. Weiters betrifft die gegenständliche Erfindung ein Mehrphasensystem umfassend eine Mehrzahl an Phasen, wobei in den Phasen jeweils ein Phasenstrom fließt, wobei Stromsensoren zur Erfassung von Strommesswerten der Phasenströme vorgesehen sind

In Mehrphasensystemen, beispielsweise elektromagnetische Transporteinheiten, wie Langstatorlinearmotoren oder Planarmotoren, werden Phasenströme der einzelnen Phasen ermittelt. Um sicherzustellen, dass bei der Ermittlung oder Verarbeitung der Phasenströme keine Fehler auftreten, ist es oftmals erwünscht die Phasenströme zu validieren, d.h. sicherzustellen, dass die ermittelten Phasenströme korrekt sind. Eine Möglichkeit zur Validierung der ermittelten Phasenströme, ist die Anwendung der Summenstromregel nach Kirchhoff. Nach dem ersten Kirchhoff sehen Gesetz entspricht die Summe aller Ströme in einem Knotenpunkt Null. Anders formuliert entspricht die Summe aller in einem Knotenpunkt zufließenden Ströme der Summe aller aus dem Knotenpunkt abfließenden Ströme. Demnach können zur Validierung der Phasenströme die Phasenströme in einem gemeinsamen Knotenpunkt zu einer Phasenstromsumme zusammengeführt werden und die Phasenstromsumme ermittelt werden. Entspricht die ermittelte Phasenstromsumme im Knotenpunkt der Summe der einzeln ermittelten Phasenströme, so können die Phasenströme validiert werden, was bedeutet, dass die Messung der Phasenströme als valide anzusehen ist. Die EP 3 109 999 A2 offenbart ein derartiges Verfahren zur Validierung der Phasenströme eines Mehrphasensystems. Weitere Beispiele aus dem Stand der Technik sind in US 2018/358888 A1, US 5 357 181 A, US 2014/266111 A1 und US 6 005 393 A zu sehen.

Bei der Ermittlung der einzelnen Phasenströme muss jedoch jeweils eine zulässige Toleranz, d.h. ein maximal zulässiger Fehler, berücksichtigt werden. Ein in einer Phase auftretender Fehler, z.B. ein Messfehler des Phasenstroms, welcher sich im Toleranzbereich befindet, kann damit jedoch nicht erkannt werden. Da für alle Phasenströme jeweils ein maximal zulässiger Fehler berücksichtigt werden muss und die Phasenströme zu einer Phasenstromsumme addiert werden, summiert sich auch der maximal zulässige Fehler. Das bedeutet, dass der maximal zulässige Fehler der Phasenstromsumme der Summe der maximal zulässigen Fehler der einzelnen Phasenströme entspricht. Damit steigt der zulässige Fehler der Phasenstromsumme mit der Anzahl der Phasen (und damit der Anzahl der zu ermittelnden Phasenströme) proportional linear an. Durch den hohen maximal zulässigen Fehler der Phasenstromsumme entsteht eine geringe Genauigkeit der Validierung der Phasenströme, da sich diese linear mit der Anzahl der Phasen verschlechtert.

Insbesondere bei einer hohen Anzahl an Phasen kann somit der zulässige Fehler der Phasenstromsumme derart hohe Werte erreichen, dass keine sinnvolle Validierung der Phasenströme auf Basis der Phasenstromsumme möglich ist, womit kein sicherer Betrieb des Mehrphasensystems sichergestellt werden kann.

Es ist daher eine Aufgabe der gegenständlichen Erfindung ein Verfahren zum sicheren Betrieb eines Mehrphasensystems auch mit einer großen Anzahl von Phasen anzugeben.

Diese Aufgabe wird erfindungsgemäß gelöst, indem eine Anzahl Phasengruppen vorgesehen ist, welche einen Teil der Phasen umfasst, wobei die Phasenströme der Anzahl Phasengruppen in einem Gruppenknoten zu einem Gruppensummenstrom zusammengeführt werden und ein Gruppensummenstrommesswert des Gruppensummenstroms von einem Gruppenstromsensor erfasst wird, wobei die der Anzahl Phasengruppen zugehörigen Strommesswerte von einer Gruppensummiereinheit zu einer Gruppensumme summiert werden, und wobei die Gruppensumme mit dem Gruppensummenstrommesswert von einer Gruppenvergleichseinheit verglichen wird, um die Phasenströme der Phasen zu validieren um den sicheren Betrieb des Mehrphasensystems sicherzustellen.

Weiters wird die Aufgabe durch ein Mehrphasensystem gelöst, bei welchem eine Anzahl Phasengruppen vorgesehen ist, welche einen Teil der Phasen umfasst, wobei ein Gruppenknoten vorgesehen ist, in welchem die Phasenströme der Anzahl Phasengruppen zu einem Gruppensummenstrom zusammengeführt sind, wobei ein Gruppenstromsensor zur Erfassung eines Gruppensummenstrommesswerts des Gruppensummenstroms vorgesehen ist, wobei eine Gruppensummiereinheit vorgesehen ist, die ausgestaltet ist die der Anzahl Phasengruppen zugehörigen Strommesswerte der Phasenströme zu einer Gruppensumme zu summieren, wobei eine Gruppenvergleichseinheit vorgesehen ist, welche ausgestaltet ist die Gruppensumme mit dem Gruppensummenstrommesswert zu vergleichen, um die Phasenströme der Phasen zu validieren um den sicheren Betrieb des Mehrphasensystems sicherzustellen.

Bei der Ermittlung eines Strommesswerts eines Phasenstroms muss eine maximale Abweichung des Strommesswerts vom tatsächlichen Phasenstrom in Form eines maximalen zulässigen Fehlers berücksichtigt werden. Es wird erfindungsgemäß ein Teil der Phasen in zumindest einer Phasengruppe in einem Gruppenknoten zusammengeführt, womit sich für die jeweiligen Phasenströme im Gruppenknoten ein Gruppensummenstrom ergibt. Weiters werden die Strommesswerte der, der zumindest einen Phasengruppe zugehörigen, Phasen zu einer Gruppensumme summiert. Damit ergibt sich für die Gruppensumme ein maximaler zulässiger Fehler als Summe der zulässigen Fehler der in der jeweiligen Phasengruppe beinhalteten Phasen. Weiters wird die Gruppensumme mit dem Gruppensummenstrommesswert verglichen um die Phasenströme der Phasengruppe zu validieren.

Würden stattdessen lediglich alle Phasen des Mehrphasensystems in einem Gesamtknoten zu einem Gesamtsummenstrom zusammengeführt und die Strommesswerte aller Phasen zu einer Gesamtsumme aufsummiert, so würde sich als maximaler zulässiger Fehler die Summe der zulässigen Fehler aller Phasen ergeben.

Erfindungsgemäß ergibt sich durch das Zusammenfassen eines Teils der Phasen in eine Phasengruppe ein maximaler zulässiger Fehler des Gruppensummenstrommesswerts, welcher geringer ist, als er es für den Gesamtsummenstrommesswert wäre. Damit kann die Validierung der Phasenströme mit einer größeren Genauigkeit vorgenommen werden. Das bedeutet, dass die Toleranz für die Abweichung vom Gruppensummenstrom zum Gruppensummenstrommesswert geringer ausfällt, womit im Rahmen der Validierung auch kleinere Fehler erkannt werden können. Durch die Zusammenfassung von Phasen in Phasengruppen wird die Genauigkeit der Validierung unabhängig von der Anzahl der Phasen bzw. Phasenströme im Mehrphasensystem. Durch diese Validierung mit einer hohen Genauigkeit kann ein sicherer Betrieb des Mehrphasensystems gewährleistet werden. Es wird mit einer geringen Fehlertoleranz sichergestellt, dass bei der Messung und/oder Verarbeitung der Phasenströme keine, oder nur kleine, Fehler auftreten. Schlägt die Validierung fehl, so kann durch eine Aktionseinheit zumindest eine Aktion ausgelöst werden, beispielsweise ein optisches und/oder akustisches Signal ausgegeben werden. Ebenso kann bei einer fehlgeschlagenen Validierung als Aktion das Mehrphasensystem oder ein Teil davon stillgelegt werden. Auch kann als Aktion beispielsweise verhindert werden, dass das Mehrphasensystem eingeschaltet wird. Ebenso kann als Aktion ein Signal generiert werden, welches, beispielsweise von einer Steuereinheit des Mehrphasensystems, weiterverarbeitet wird.

Das Prinzip der Bildung von Phasengruppen zur Erhöhung der Genauigkeit der sicheren Ermittlung eines Phasenstroms lässt sich auf alle beliebigen physikalischen Messprinzipien der Strommessung anwenden und kann auch in inhomogenen Systemen mit einer diversitären Strommessung verwendet werden. Phasengruppen können somit unabhängig vom verwendeten Messprinzip (Verwendung von Shunts, Nutzung des Hall-Effekts, ...) gebildet werden, wobei im erfindungsgemäßen Verfahren zur Messung unterschiedlicher Ströme dieselben oder zumindest teilweise unterschiedliche Messprinzipien verwendet werden können.

Natürlich können zusätzlich zum erfindungsgemäßen Verfahren auch alle Phasen in einem Gesamtknoten zu einem Gesamtsummenstrom zusammengefasst und ein Gesamtsummenstrommesswert ermittelt werden, welcher mit der Summe der Strommesswerte aller Phasen verglichen wird. Eine (zusätzliche) Validierung auf Basis des Gesamtsummenstroms unterliegt jedoch einem maximalen zulässigen Fehler als Summe der maximalen zulässigen Fehler aller Phasen.

Vorzugsweise werden die Phasenströme aller Phasen des Mehrphasensystems auf eine Anzahl Phasengruppen aufgeteilt, in jeder Phasengruppe jeweils die Phasenströme in einem Gruppenknoten zu einem Gruppensummenstrom zusammengeführt und jeweils ein Gruppensummenstrommesswert des Gruppensummenstroms erfasst, wobei in jeder Phasengruppe die Strommesswerte der Phasenströme jeweils von einer Gruppensummiereinheit zu einer Gruppensumme summiert werden, und wobei pro Phasengruppe die Gruppensummen jeweils von einer Gruppenvergleichseinheit mit dem zugehörigen Gruppensummenstrommesswerten verglichen werden, um die Phasenströme aller Phasen innerhalb der Anzahl Phasengruppen zu validieren.

Durch die Aufteilung aller Phasen auf Phasengruppen können die Phasenströme aller Phasen validiert werden. Es ergibt sich somit für jede Phasengruppe ein maximaler zulässiger Fehler als Summe der zulässigen Fehler der in der jeweiligen Phasengruppe beinhalteten Phasen. Da jede Phasengruppe nur einen Teil der Phasen des Mehrphasensystems umfasst, ergibt sich als maximaler zulässiger Fehler der in der Phasengruppe enthaltenen Phasen somit ein geringerer maximaler zulässiger Fehler der Validierung als es für einen Gesamtsummenstrom der Fall wäre. Gesamtheitlich betrachtet hängt die Genauigkeit der Validierung der Phasenströme aller Phasen vom größten maximalen zulässigen Fehler der beteiligten Phasengruppen ab.

Es kann die Anzahl Phasengruppen jeweils dieselbe Anzahl an Phasen umfassen. Damit ergibt sich ein symmetrischer und einfacher Aufbau. Die Phasengruppen können auch ineinander verschachtelt werden. Vorzugsweise ist jedoch jede Phase nur von einer Phasengruppe umfasst, insbesondere wenn alle Phasen auf Phasengruppen aufgeteilt sind.

Es können auch Phasengruppen mit einer unterschiedlichen Anzahl an Phasen vorgesehen sein. Dies kann insbesondere vorteilhaft sein, wenn bei der Ermittlung der Strommesswerte der jeweiligen Phasen unterschiedliche maximale zulässige Fehler zu erwarten sind. Dies kann insbesondere der Fall sein, wenn diversitäre Sensoren verwendet werden.

Es kann vorteilhaft sein, wenn Phasen, deren Strommesswerte einen größeren maximalen zulässigen Fehler aufweisen, in kleinere Phasengruppen, d.h. Phasengruppen mit weniger Phasen aufgenommen werden und Phasen, deren Strommesswerte einen kleineren maximalen zulässigen Fehler aufweisen, in größere Phasengruppen, d.h. Phasengruppen mit mehr Phasen aufgenommen werden.

Vorzugweise werden die Strommesswerte der Phasenströme entsprechend einer vorgegebenen Sicherheitsanforderung sicher erfasst, wobei vorzugsweise für die Ermittlung der Strommesswerte eine Einfehlersicherheit als Sicherheitsanforderung gefordert wird.

Erfolgt eine Ermittlung der Strommesswerte mittels einer Sigma-Delta-Wandlung, so kann diese Sicherheitsanforderung eine Implementierung in einem FPGA betreffen, bei LEM-Wandlern einen ADC-Wandler betreffen.

Das erfindungsgemäße Verfahren kann in allen Mehrphasensystemen mit einer Mehrzahl von n>2 Phasen Anwendung finden, insbesondere bei Langstatorlinearmotoren oder Planarmotoren. Sollen alle Phasen des Mehrphasensystems in Phasengruppen zusammengefasst werden, so ist eine Mehrzahl von n>3 Phasen erforderlich. Bei einer Anzahl von vier Phasen können beispielsweise zwei Phasengruppen mit jeweils zwei Phasen vorgesehen sein.

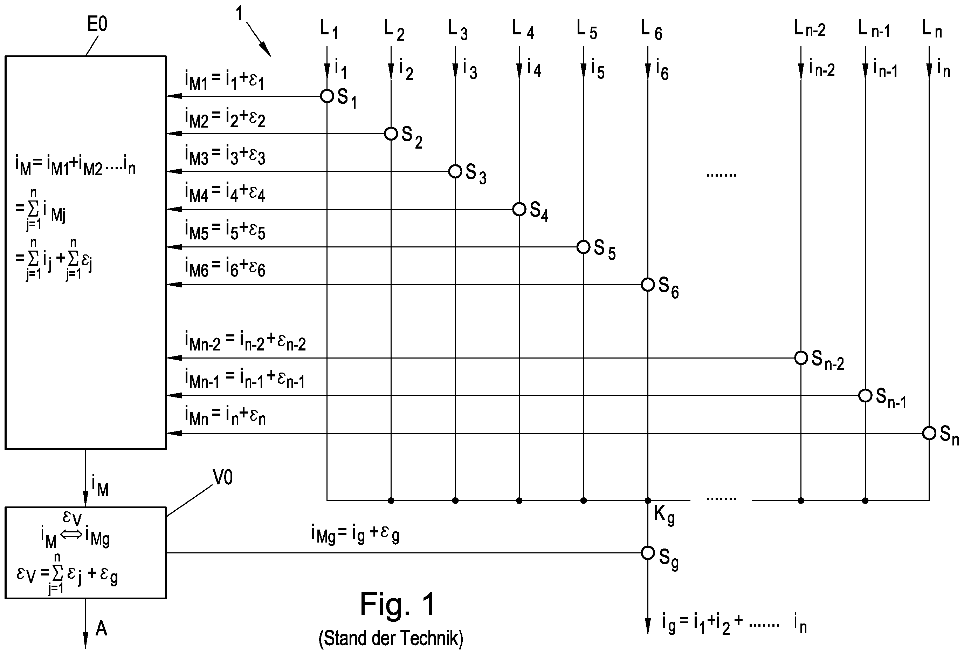

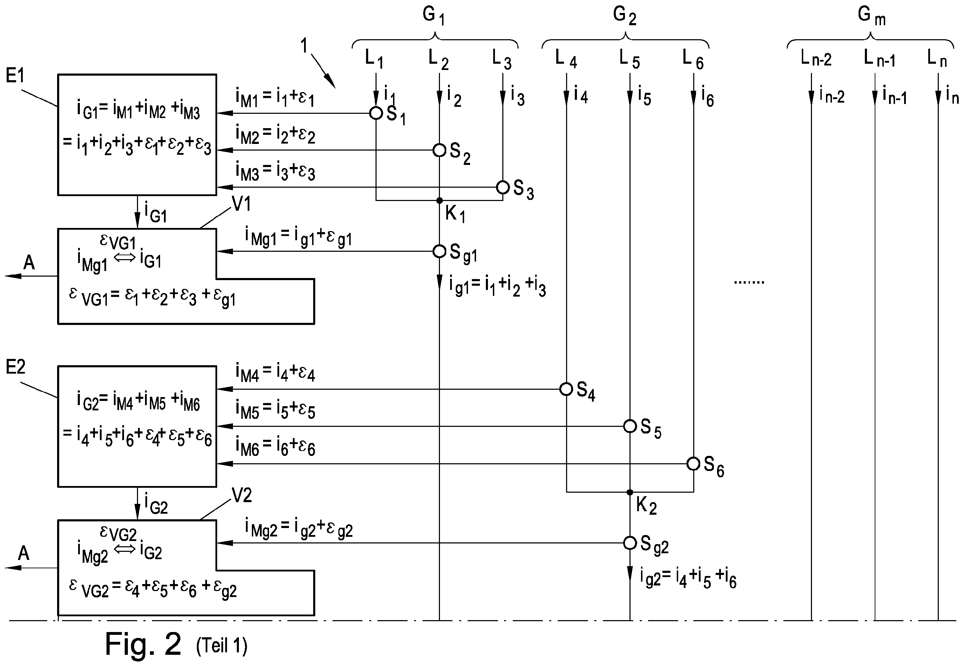

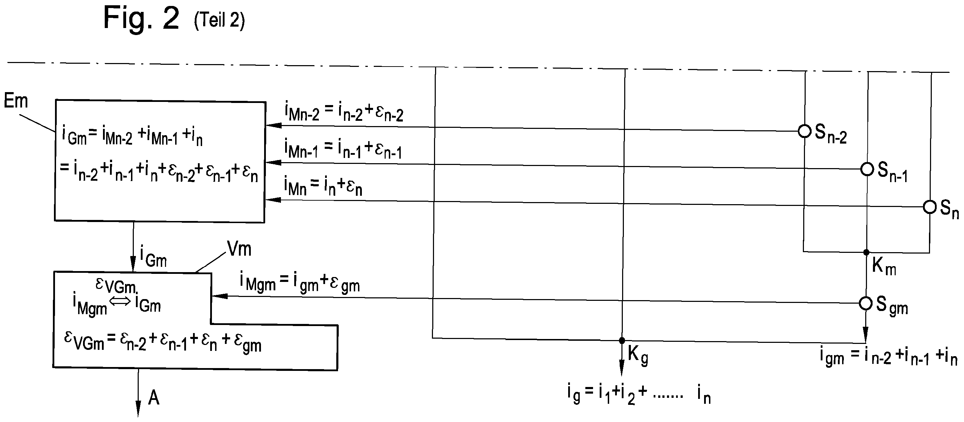

Die gegenständliche Erfindung wird nachfolgend unter Bezugnahme auf die Figuren 1 und 2 näher erläutert, die beispielhaft, schematisch und nicht einschränkend vorteilhafte Ausgestaltungen der Erfindung zeigen. Dabei zeigt

Fig.1    eine Validierung der Phasenströme nach dem Stand der Technik,

Fig. 2    eine Validierung der Phasenströme in jeweiligen Phasengruppen.

Fig. 1 stellt eine Validierung von n Phasenströmen $i_1,..., i_n$ eines Mehrphasensystems 1 nach dem Stand der Technik dar. Das Mehrphasensystem 1 kann beispielsweise ein elektromagnetisches Transportsystem, z.B. einen Langstatorlinearmotor oder Planarmotor, darstellen und umfasst eine Mehrzahl n an Phasen $L_1,..., L_n$. Es fließt in jeder Phase $L_1,..., L_n$ ein Phasenstrom $i_1,..., i_n$, wobei in jeder Phase Phase $L_1,..., L_n$ ein Phasenstromsensor $S_1, ..., S_n$ zur Ermittlung eines Strommesswerts $i_{M1},..., i_{Mn}$ des Phasenstrom $i_1, ... , i_n$ vorgesehen ist. Die einzelnen Strommesswerte $i_{M1},...,i_{Mn}$ weisen z.B. auf Grund von systembedingten Messfehlern gegenüber dem tatsächlichen Phasenstrom $i_1,..., i_n$ jeweils einen maximalen Fehler $\varepsilon_1,..., \varepsilon_n$ auf. Dieser maximale Fehler $\varepsilon_1,..., \varepsilon_n$ muss jeweils bei der Validierung berücksichtigt werden. Damit setzt sich der erste Strommesswert $i_{M1}$ aus dem ersten Phasenstrom $i_1$ und einem ersten maximalen Fehler $\varepsilon_1$ zusammen: $i_{M1} = i_1 + \varepsilon_1$, der zweite Strommesswert $i_{M2}$ aus dem zweiten Phasenstrom $i_2$ und einem zweiten maximalen Fehler $\varepsilon_2$ zusammen: $i_{M2} = i_2 + \varepsilon_2$, etc., und der n-te Strommesswert $i_{Mn}$ aus dem n-ten Phasenstrom $i_n$ und einem n-ten maximalen Fehler $\varepsilon_n$ zusammen: $i_{Mn} = i_n + \varepsilon_n$.

Die maximalen Fehler $\varepsilon_1, ..., \varepsilon_n$ selbst können jeweils positiv oder negativ angenommen werden, wobei als maximal möglicher Fehler $\varepsilon_1, ..., \varepsilon_n$ auch ein Fehlertoleranzband angenommen werden kann. Ein positiver maximaler Fehler $\varepsilon_1, ..., \varepsilon_n$ bedeutet eine maximal mögliche Überschreitung des jeweiligen Phasenstroms $i_1,..., i_n$ durch den zugehörigen Strommesswert $i_{M1},..., i_{Mn}$, ein negativer maximaler Fehler $\varepsilon_1, ..., \varepsilon_n$ eine maximal mögliche Unterschreitung des jeweiligen Phasenstroms $i_1,..., i_n$ durch den zugehörigen Strommesswert $i_{M1},..., i_{Mn}$. Ein maximaler Fehler $\varepsilon_1, ..., \varepsilon_n$ als Toleranzband bedeutet, dass die maximal mögliche Überschreitung und/oder Unterschreitung des jeweiligen Phasenstroms $i_1,..., i_n$ durch den zugehörigen Strommesswert $i_{M1},..., i_{Mn}$ angenommen wird.

In einer Summiereinheit E0 werden die Strommesswerte $i_{M1},... ,i_{Mn}$ zu einer $n$ Messwertgesamtsumme

$$i_M = \sum_{j=1}^{n} i_{Mj}$$

aufsummiert. Die Messwertgesamtsumme $i_M$ umfasst somit die Summe der n Phasenströme $i_1,... ,i_n$, beaufschlagt mit der Summe der maximalen $n$ $n$ Fehler $\varepsilon_1, ..., \varepsilon_n$:

$$i_M = \sum_{j=1}^{n} i_{Mj} = \sum_{j=1}^{n} i_j + \sum_{j=1}^{n} \varepsilon_j$$

. Weiters werden die Phasenströme $i_1,... ,i_n$ in einem Gesamtknoten $K_g$ zu einem Summenstrom $i_g$ zusammengeführt, womit sich für den Summenstrom $i_g = i_1+i_2+ ... +i_n$ ergibt. Es wird ein Summenstrommesswert $i_{Mg}$ des Summenstroms $i_g$, hier mittels eines Summenstromsensor $S_g$ ermittelt, wobei der Summenstrommesswert $i_{Mg}$ ebenso einen maximalen Fehler $\varepsilon_g$ aufweist und sich somit aus dem Summenstrom $i_g$ und dem maximalen Fehler $\varepsilon_g$ ergibt: $i_{Mg} = i_g + \varepsilon_g$.

Grundlegend könnten positive maximale Fehler $\varepsilon_1,..., \varepsilon_n$ und/oder negative maximale Fehler $\varepsilon_1,..., \varepsilon_n$ separat addiert werden, insbesondere, wenn für die positiven und negativen maximalen Fehler $\varepsilon_1, ..., \varepsilon_n$ unterschiedliche Werte angenommen werden. Wird als maximaler möglicher Fehler $\varepsilon_1,..., \varepsilon_n$ ein Fehlertoleranzband angenommen, so bedeutet eine Summierung der der maximalen Fehler $\varepsilon_1,..., \varepsilon_n$ eine Ausweitung des Fehlertoleranzbands. Zur leichteren Veranschaulichung wird lediglich in allgemeiner Weise eine Addition der maximalen Fehler $\varepsilon_1,..., \varepsilon_n$ dargestellt. Eine Summierung der maximalen Fehler $\varepsilon_1,..., \varepsilon_n$ kann grundlegend für negative maximale Fehler $\varepsilon_1,..., \varepsilon_n$ erfolgen und/oder für maximale Fehler $\varepsilon_1,..., \varepsilon_n$ und/oder für maximale Fehler $\varepsilon_1,..., \varepsilon_n$ in Form eines Toleranzbands.

Es wird nunmehr von einer Vergleichseinheit V0 die Messwertgesamtsumme $i_M$ mit dem Summenstrommesswert $i_{Mg}$ verglichen, wobei bei einer ausreichend genauen Übereinstimmung die Phasenströme $i_1,..., i_n$ validiert werden. Schlägt die Validierung fehl, so wird beispielsweise eine Aktion A ausgelöst.

Bei der Validierung müssen jedoch die maximalen Fehler $\varepsilon_1,..., \varepsilon_n$ der Strommesswerte $i_{M1},..., i_{Mn}$ und der maximale Fehler $\varepsilon_g$ des Summenstrommesswert $i_{Mg}$ berücksichtigt werden, wie es in Fig. 1 allgemein dargestellt ist. Die maximalen Fehler $\varepsilon_1,..., \varepsilon_n$ der Strommesswerte $i_{M1},..., i_{Mn}$ gegenüber den Phasenströmen $i_1,... , i_n$ fließen also in die Messwertgesamtsumme $i_M$ ein. Beim Vergleich der Messwertgesamtsumme $i_M$ mit dem Summenstrommesswerts $i_{Mg}$ (in Fig. 1 als $i_M \Leftrightarrow i_{Mg}$ dargestellt) werden weiters nicht nur die maximalen Fehler $\varepsilon_1,..., \varepsilon_n$ der Strommesswerte $i_{M1},..., i_{Mn}$, sondern auch der maximale Fehler $\varepsilon_g$ des Summenstrommesswert $i_{Mg}$ gegenüber dem Summenstrom $i_g$ berücksichtigt.

Damit ergibt sich insbesondere bei einer hohen Mehrzahl n an Phasen $L_1,..., L_n$ ein hoher maximaler zulässiger Gesamtfehler

$$\varepsilon_V = \varepsilon_1 + \varepsilon_2 + ... \varepsilon_n + \varepsilon_g = \sum_{j=1}^{n} \varepsilon_j + \varepsilon_g$$

für die Validierung der Phasenströme $i_1, ... , i_n$. Somit kann ein auftretender Fehler, welcher bewirkt, dass der Summenstrommesswert $i_{Mg}$ um weniger als den maximalen

$$\varepsilon_V = \sum_{j=1}^{n} \varepsilon_j + \varepsilon_g$$

zulässigen Gesamtfehler von der Messwertgesamtsumme $i_M$ abweicht, nicht erkannt werden. Dieser auftretende Fehler kann einen Phasenstrom $i_1,... , i_n$ betreffen oder sich aus mehreren auftretenden Fehlern betreffend mehrere Phasenströme $i_1,..., i_n$ akkumulieren.

Unter der Annahme, dass die maximalen Fehler $\varepsilon_1,..., \varepsilon_n$ der Strommesswerte $i_{M1},..., i_{Mn}$ und der maximale Fehler $\varepsilon_g$ des Summenstrommesswerts $i_{Mg}$ jeweils dem identischen maximalen Fehler $\varepsilon_1 = \varepsilon_2 = ... = \varepsilon_n = \varepsilon_x$ entsprechen (nicht dargestellt), ergibt sich für die Messwertgesamtsumme $i_M$ die Summe der Phasenstrome $i_1,..., i_n$ beaufschlagt mit dem n-fachen maximalen Fehler $\varepsilon_x$: $i_M = i_1 + i2 +,...,+ i_n + n\,\varepsilon_x$. Dem gegenüber entspricht der Summenstrommesswert $i_{Mg}$ der Summe der Phasenstrome $i_1,..., i_n$ beaufschlagt mit dem maximalen Fehler $\varepsilon_x$: $i_{Mg} = i_g + \varepsilon_x = i_1 + i_2 +,...,+ i_n + \varepsilon_x$. Um nun einen Vergleich der Messwertgesamtsumme $i_M$ mit dem Summenstrommesswert $i_{Mg}$ $\overset{\varepsilon_V}{(i_M \Leftrightarrow i_{Mg})}$ anstellen zu können, muss also ein maximaler zulässiger Gesamtfehler in der Größe von $\varepsilon_v = (n+1)\,\varepsilon_x$ als Fehlergrenze berücksichtigt werden, wobei der Faktor n aus der Ermittlung der Strommesswerte $i_{M1},..., i_{Mn}$ stammt und der Anzahl der Phasen $L_1,..., L_n$ entspricht während der zusätzliche Faktor 1 auf die Messung des Summenstrommesswerts $i_{Mg}$ zurückzuführen ist.

Das bedeutet, dass im Zuge der Validierung ein auftretender Fehler, welcher bewirkt, dass der Summenstrommesswert $i_{Mg}$ um weniger als den maximalen zulässigen Gesamtfehler $\varepsilon_v = (n+1)\,\varepsilon_x$ von der Messwertgesamtsumme $i_M$ abweicht, nicht detektiert werden kann.

Wird als Mehrphasensystem 1 ein Langstatorlinearmotor betrieben, welcher beispielsweise eine Mehrzahl von n=42 Phasen $L_1,..., L_{n=42}$ aufweist, so ergibt bei der Aufsummierung der Strommesswerte $i_{M1}, ... , i_{Mn=42}$ zu einer Messwertgesamtsumme $i_M$ und dem Vergleich mit dem Summenstrommesswert $i_{Mg}$ des Summenstroms $i_g$ ein maximaler zulässiger Gesamtfehler r von $\varepsilon_v = \varepsilon_1 + \varepsilon_1 + ... \varepsilon_{n=42} + \varepsilon_g$.

Unter der Annahme, dass die maximalen Fehler $\varepsilon_1,... , \varepsilon_{n=42}$ der Strommesswerte $i_{M1}, ..., i_{Mn=42}$ und der maximale Fehler $\varepsilon_g$ des Summenstromwerts $i_{Mg}$ jeweils einem maximalen Fehler $\varepsilon_x$ von 100 mA entsprechen, ergibt sich als maximaler zulässiger Gesamtfehler von $\varepsilon_v = (n+1)\,\varepsilon_x = 43*100$ mA = 4,3A. Das bedeutet, dass im Rahmen der Validierung einzelne auftretende Fehler von Strommesswerten $i_{M1}, ... i_{Mn}$, oder auch akkumulative Fehler die in Summe einen gesamten Fehler ergeben, die geringer als der maximale zulässige Gesamtfehler $\varepsilon_v = 4,3$ A sind, nicht erkannt werden.

Dem gegenüber ist in Fig. 2 eine bevorzugte Ausgestaltung des erfindungsgemäßen Verfahrens und der erfindungsgemäßen Vorrichtung dargestellt. Es ist gleichermaßen ein Mehrphasensystem 1 mit einer Mehrzahl n an Phasen $L_1,..., L_n$ dargestellt, wobei in jeder Phase $L_1,..., L_n$ Phasenstromsensoren $S_1, ..., S_n$ zur Messung der jeweiligen Phasenströme $i_1, ... , i_n$ vorgesehen sind. Es wird also für jeden Phasenstrom $i_1,..., i_n$ ein Strommesswert $i_{M1}, ..., i_{Mn}$ ermittelt. Die einzelnen Strommesswerte $i_{M1},..., i_{Mn}$ weisen wiederum jeweils einen maximalen Fehler $\varepsilon_1,..., \varepsilon_n$ auf. Damit ergibt sich wie oben anhand der Fig. 1 beschrieben für den ersten Strommesswert $i_{M1}$ der erste Phasenstrom $i_1$ samt einem ersten maximalen Fehler $\varepsilon_1$: $i_{M1} = i_1 + \varepsilon_1$, für den zweiten Strommesswert $i_{M2}$ der zweite Phasenstrom $i_2$ samt einem zweiten maximalen Fehler $\varepsilon_2$: $i_{M2} = i_2 + \varepsilon_2$, bis zum n-ten Strommesswert $i_{Mn}$, welcher sich aus dem n-ten Phasenstrom $i_n$ und einem n-ten maximalen Fehler $\varepsilon_n$ zusammensetzt: $i_{Mn} = i_n + \varepsilon_n$.

Im Gegensatz zur Fig. 1 ist jedoch eine Mehrzahl m>1 Phasengruppen $G_1,..., G_m$ vorgesehen, welche jeweils einen Teil der Phasen $L_i,..., L_n$ umfassen. Erfindungsgemäß umfasst jede Phasengruppe $G_1,..., G_m$ einen Teil der Mehrzahl n Phasen $L_1,..., L_n$. Die Anzahl der von einer Phasengruppe $G_1,..., G_m$ umfassten Phasen $L_1,..., L_n$ wird in Folge als Gruppenphasenanzahl $p_1,..., p_m$ bezeichnet. Es kann die Gruppenphasenanzahl $p_1,..., p_m$ der Phasengruppen $G_1,..., G_m$ identisch sein, oder zumindest teilweise zwischen den Phasengruppen $G_1,..., G_m$ variieren. In Fig. 2 umfasst jede Phasengruppe $G_1,..., G_m$ jeweils drei Phasen, womit die Gruppenphasenanzahl $p_1, .. p_m$ einer jeder Phasengruppe $G_1,..., G_m$ drei ist.

Es kann auch vorgesehen sein, dass die Anzahl m Phasengruppen $G_1,..., G_m$ in Summe lediglich einen Teil der Phasen $L_1,..., L_n$ des Mehrphasensystems 1 umfassen. Damit wird jedoch nur für diesen Teil der Phasen $L_1,..., L_n$ der jeweilige Phasenstrom $i_1,..., i_n$ erfindungsgemäß validiert.

In jeder Phasengruppe $G_1,..., G_m$ werden die Strommesswerte $i_{M1},..., i_{Mn}$ der zugehörigen Phasen $L_1,..., L_n$ jeweils von einer Gruppensummiereinheit $E_1, E_2,..., E_m$ zu einer Gruppensumme $i_{G1},..., i_{Gm}$ aufsummiert.

Die Gruppenvergleichseinheiten $V_1,..., V_m$

und/oder Gruppensummiereinheiten $E_1$, $E_2$,..., $E_m$ können integraler Bestandteil des Mehrphasensystems sein, beispielsweise auf einer Steuereinheit des Mehrphasensystems 1, z.B. eines elektromagnetischen Transportsystems, integriert sein. Gleiches gilt für die Aktionseinheit, sofern eine vorgesehen ist. Die Gruppenvergleichseinheiten $V_1$,... ,$V_m$ und/oder Gruppensummiereinheiten $E_1$, $E_2$,..., $E_m$ und/oder Aktionseinheit können jeweils als Hardware oder Software ausgeführt sein.

So werden beispielsweise für die erste Phasengruppe $G_1$ der erste Strommesswert $i_{M1}$, der zweite Strommesswert $i_{M2}$ und der dritte Strommesswert $i_{M3}$ zu einer ersten Gruppensumme $i_{G1}$ aufsummiert, womit die erste Gruppensumme $i_{G1}$ somit die Summe des ersten, zweiten und dritten Phasenstroms $i_1$, $i_2$, $i_3$ beaufschlagt mit der Summe des ersten, zweiten und dritten maximalen Fehlers $\varepsilon_1$, $\varepsilon_2$, $\varepsilon_3$ umfasst: $i_{G1} = i_1 + i_2 + i_3 + \varepsilon_1 + \varepsilon_2 + \varepsilon_3$, die zweite Gruppensumme $i_{G2}$ die Summe des vierten, fünften und sechsten Phasenstroms $i_4$, $i_5$, $i_6$ beaufschlagt mit der Summe des vierten, fünften und sechsten maximalen Fehlers $\varepsilon_4$, $\varepsilon_5$, $\varepsilon_6$ umfasst: $i_{G2} = i4 + i_5 + i_6 + \varepsilon_4 + \varepsilon_5 + \varepsilon_6$, etc., und die m-te Gruppensumme $i_{Gm}$ die Summe des n-2ten, n-1ten und n-ten Phasenstroms $i_{n-2}$, $i_{n-1}$, $i_n$ beaufschlagt mit der Summe des n-2ten, n-1ten und n-ten maximalen Fehlers $\varepsilon_{n-2}$, $\varepsilon_{n-1}$, $\varepsilon_n$ umfasst: $i_{Gm} = i_{n-2} + i_{n-1} + i_n + \varepsilon_{n-2} + \varepsilon_{n-1} + \varepsilon_n$.

Weiters werden die Phasenströme $i_1$,... , $i_n$ jeder Phasengruppe $G_1$,..., $G_m$ in einem Gruppenknoten $K_1$,..., $K_m$ zu einem Gruppensummenstrom $i_{g1}$,..., $i_{gm}$ zusammengeführt, womit sich für den jeweiligen Gruppensummenstrom $i_{g1}$,..., $i_{gm}$ jeweils die Summe der in der Gruppe enthaltenen Phasenströme $i_1$,..., $i_n$ ergibt. Es wird jeweils unter Verwendung eines Gruppenstromsensors $S_{g1}$,..., $S_{gm}$ ein Gruppensummenstrommesswert $i_{Mg1}$, ..., $i_{Mgm}$ der Guppensummenströme $i_{g1}$,..., $i_{gm}$ ermittelt, wobei die Gruppensummenstrommesswerte $i_{Mg1}$, ..., $i_{Mgm}$ gegenüber den zugehörigen Guppensummenströmen $i_{g1}$,..., $i_{gm}$ jeweils ebenso einen maximalen Fehler $\varepsilon_{g1}$,..., $\varepsilon_{gm}$ aufweisen.

So setzt sich beispielsweise der erste Gruppensummenstrommesswert $i_{Mg1}$ der ersten Phasengruppe $G_1$ aus dem ersten, zweiten und dritten Phasenstrom $i_1$, $i_2$, $i_3$ und dem maximalen Fehler $\varepsilon_{g1}$ zusammen, etc.

Es werden erfindungsgemäß jeweils von einer Gruppenvergleichseinheit $V_1$,... ,$V_m$ die Gruppensummenstrommesswerte $i_{Mg1}$,..., $i_{Mgm}$ mit den zugehörigen Gruppensummen $i_{G1}$,..., $i_{Gm}$ verglichen (in Fig. 2 als

$$i_{Mg1} \overset{\varepsilon_{VG1}}{\Longleftrightarrow} i_{G1} \,,\, i_{Mg2} \overset{\varepsilon_{VG2}}{\Longleftrightarrow} i_{G2} \,,..., \, i_{Mgm} \overset{\varepsilon_{VGm}}{\Longleftrightarrow} i_{Gm}$$ bezeichnet)

um die Phasenstrome $i_1$,... ,$i_n$ zu validieren.

Schlägt die Validierung fehl, d.h. weicht der jeweilige Gruppensummenstrommesswert $i_{Mg1}$,..., $i_{Mgm}$ von der zugehörigen Gruppensumme $i_{G1}$,..., $i_{Gm}$ ab, so kann durch eine Aktionseinheit (nicht dargestellt) eine Aktion A ausgelöst werden. Als Aktion kann beispielsweise ein optisches und/oder akustisches Signal ausgegeben und/oder zumindest ein Teil des Mehrphasensystems 1 stillgelegt, werden.

Es müssen wiederum in jeder Gruppenvergleichseinheit $V_1$,..., $V_m$ jeweils die maximalen Fehler $\varepsilon_1$,..., $\varepsilon_n$ der Strommesswerte $i_{M1}$,..., $i_{Mn}$ (über die Gruppensumme $i_{G1}$,..., $i_{Gm}$) und der maximale Fehler $\varepsilon_{g1}$,... , $\varepsilon_{gm}$ des jeweiligen Gruppensummenstrommesswerts $i_{Mg1}$, ..., $i_{Mgm}$ berücksichtigt werden. Damit umfasst der maximale zulässige Gruppengesamtfehler $\varepsilon_{V1}$, $\varepsilon_{V2}$,..., $\varepsilon_{Vm}$ jeder Phasengruppe $G_1$,... , $G_m$ lediglich die Summe der maximalen Fehler $\varepsilon_1$, ..., $\varepsilon_n$ der Strommesswerte $i_{M1}$,... ,$i_{Mn}$ der Phasen $L_1$,..., $L_n$, die in der jeweiligen Phasengruppe $G_1$,... , $G_m$ beinhaltet sind, und den maximalen Fehler $\varepsilon_{g1}$,... , $\varepsilon_{gm}$ des zugehörigen Gruppensummenstrommesswerts $i_{Mg1}$,..., $i_{Mgm}$.

Beim Vergleich des ersten Gruppensummenstrommesswerts $i_{Mg1}$ mit der zugehörigen ersten Gruppensumme $i_{G1}$ $(i_{Mg1} \overset{\varepsilon_{VG1}}{\Longleftrightarrow} i_{G1})$ ergibt sich somit für die erste Gruppe G1 beispielsweise lediglich ein maximaler zulässiger Gruppengesamtfehler $\varepsilon_{VG1} = \varepsilon_1 + \varepsilon_2 + \varepsilon_3 + \varepsilon_{g1}$, beim Vergleich des zweiten Gruppensummenstrommesswerts $i_{Mg2}$ mit der zugehörigen zweiten Gruppensumme $i_{G2}$ $(i_{Mg2} \overset{\varepsilon_{VG2}}{\Longleftrightarrow} i_{G2})$ ein maximaler zulässiger Gruppengesamtfehler $\varepsilon_{VG2} = \varepsilon_4 + \varepsilon_5 + \varepsilon_6 + \varepsilon_{g2}$,... , beim Vergleich des m-ten Gruppensummenstrommesswerts $i_{Mgm}$ mit der zugehörigen m-ten Gruppensumme $i_{Gm}$ $(i_{Mgm} \overset{\varepsilon_{VGm}}{\Longleftrightarrow} i_{Gm})$ ein maximaler zulässiger Gruppengesamtfehler $\varepsilon_{VGm} = \varepsilon_{n-2} + \varepsilon_{n-1} + \varepsilon_n + \varepsilon_{gm}$, Für den allgemeinen Fall einer Phasengruppe Gy heißt das also, dass sich der maximale zulässige Gruppengesamtfehler $\varepsilon_{Vgy}$ zusammensetzt aus den maximalen Fehlern der Phasengruppe Gy: $\sum^{py} \varepsilon_j$ wobei eine Gruppenphasenanzahl $p_y$ maximaler Fehler, d.h. einer pro in der Phasengruppe Gy enthaltener Phase ($p_y$ ist die Gruppenphasenanzahl der Phasengruppe Gy), summiert werden und zusätzlich der maximale Fehler $\varepsilon_{g1}$,..., $\varepsilon_{gm}$ des der Phasengruppe $G_y$ zugehörigen Gruppensummenstrommesswerts $i_{Mgy}$ berücksichtigt wird. Der maximale zulässige Gruppengesamtfehler $\varepsilon_{Vgy}$ für die Phasengruppe $G_y$ entspricht somit $\varepsilon_{VGy} = \sum^{py} \varepsilon_j + \varepsilon_{gy}$ . Der maximal zulässige Gruppengesamtfehler $\varepsilon_{Vgy}$ wird bei der Validierung, d.h. dem Vergleich des Gruppensummenstrommesswerts $i_{Mg1}$,..., $i_{Mgm}$ mit der zugehörigen Gruppensumme $i_{G1}$,..., $i_{Gm}$ berücksichtigt. Die Validierung schlägt fehl, wenn der Gruppensummenstrommesswert $i_{Mg1}$,..., $i_{Mgm}$ um mehr als den maximal zulässigen Gruppengesamtfehler $\varepsilon_{Vgy}$ von der zugehörigen Gruppensumme $i_{G1}$,..., $i_{Gm}$ abweicht.

Es sei wieder angenommen, dass die maximalen Fehler $\varepsilon_1$, ..., $\varepsilon_n$ der Strommesswerte $i_{M1}$,..., $i_{Mn}$ und die maximalen Fehler $\varepsilon_{g1}$,..., $\varepsilon_{gm}$ der Gruppensummenstrommesswerte $i_{Mg1}$,..., $i_{Mgm}$ jeweils dem maximalen Fehler $\varepsilon_x$ entsprechen (nicht dargestellt). Damit ergibt sich für die Gruppensumme $i_{G1}$,..., $i_{Gm}$ jeder Phasengruppe $G_1$,... , $G_m$ die Summe der zugehörigen Phasenstrome $i_1$, ... , $i_n$ beaufschlagt mit einem dreifachen maximalen Fehler $\varepsilon_x$ (hier dreifach, da die Gruppenphasenanzahl $p_1$, $p_2$,..., $p_m$ jeweils drei ist): $i_{G1} = i_1 + i_2 + i_3 + 3\,\varepsilon_x$, $i_{G2} = i4 + i_5 + i_6 + 3\,\varepsilon_x$, $i_{Gm} = i_{n-2} + i_{n-1} + i_n + 3\,\varepsilon_x$.

Weiters ergibt sich für die Gruppensummenstrommesswerte $i_{Mg1}$, ..., $i_{Mgm}$ am Gruppenknoten $K_1$,... ,$K_m$ die Summe der in der Gruppe $G_1$,... , $G_m$ enthaltenen Phasenstrome $i_1$, ... ,$i_n$ beaufschlagt mit dem maximalen Fehler $\varepsilon$: $i_{Mg1} = i_{g1} + \varepsilon_x = i_1 + i_2 + i_3 + \varepsilon_x$, $i_{Mg2} = i_{g2} + \varepsilon_x = i4 + i_5 + i_6 + \varepsilon_x$,..., $i_{Mgm} = i_{gm} + \varepsilon_x = i_{n-2} + i_{n-1} + i_n + \varepsilon_x$. Um nun zwecks der Validierung der Phasenströme $i_1$, ... , $i_n$ in den Phasengruppen $G_1$,... , $G_m$ die Gruppensummen $i_{G1}$,..., $i_{Gm}$ mit den zugehörigen Gruppensummenstrommesswerten $i_{Mg1}$,..., $i_{Mgm}$ vergleichen zu können, muss für jede Gruppe $G_1$,... , $G_m$ lediglich ein maximaler zulässiger Gruppengesamtfehler $\varepsilon_{VG1}$,... , $\varepsilon_{VG1}$ der jeweiligen Gruppe $G_1$,... , Gm in der Höhe $\varepsilon_{VG1}$ = $(3+1)\,\varepsilon_x$ , $\varepsilon_{VG2=}$ $(3+1)\,\varepsilon_x$ ,..., $\varepsilon_{VGm=}$ $(3+1)\,\varepsilon_x$ berücksichtigt werden, wobei der jeweilige Faktor 3 der Gruppenphasenanzahl $p_1$,..., $p_m$ entspricht und aus der Ermittlung der Strommesswerte $i_{M1}$, ... ,$i_{Mn}$ der in der jeweiligen Gruppe $G_1$,..., $G_m$ enthaltenen Phasen stammt, wobei der zusätzliche Faktor 1 aus der Ermittlung der Gruppensummenstrommesswerte $i_{Mg1}$, ..., $i_{Mgm}$ stammt.

Wird nun als Vergleich zum Stand der Technik wiederum als Mehrphasensystem 1 ein Langstatorlinearmotor betrieben, welcher eine Mehrzahl von n=42 Phasen $L_1$,..., $L_n$ aufweist, so ergibt sich bei einer Aufteilung der Phasen $L_1$,..., $L_n$ auf eine Anzahl m=14 Phasengruppen $G_1$,... , $G_{m=14}$ mit jeweils einer Gruppenphasenanzahl $p_1$,..., $p_m$ =3 und einem maximalen Fehler $\varepsilon_x$ von beispielsweise 100 mA pro Phasengruppe $G_1$,..., $G_m$ ein maximaler zulässiger Gruppengesamtfehler $\varepsilon_{VG1}$,..., $\varepsilon_{VG14}$ von $\varepsilon_{VG1}$,..., $\varepsilon_{VG14}$= $(p+1)\,\varepsilon_x$ = 4*100 mA = 0,4 A.

Das bedeutet, dass im Rahmen der Validierung lediglich einzelne Fehler geringer als der maximale zulässige Gruppengesamtfehler $\varepsilon_{VG}$ = $(p+1)\,\varepsilon_x$ = 0,4 A sind, nicht erkannt werden. Somit weist die erfindungsgemäße Validierung gegenüber einer Validierung via eines Summenstrommesswerts $i_{Mg}$ entsprechend Fig.1 eine weitaus höhere Genauigkeit auf, im beschriebenen Beispiel um den Faktor 10,75 höher. Somit weist die erfindungsgemäße Validierung eine hohe Genauigkeit auf, womit ein sicherer Betrieb des Mehrphasensystems 1 gewährleistet werden kann.

**Patentansprüche**

1. Verfahren zum sicheren Betrieb eines Mehrphasensystems (1), wobei in einer Mehrzahl (n) von Phasen ($L_1$, ..., $L_n$) des Mehrphasensystems (1) jeweils ein Phasenstrom (ii,..., $i_n$) fließt und wobei für eine Validierung der Phasenströme ($i_1$,..., $i_n$) Strommesswerte ($i_{M1}$, ..., $i_{Mn}$) der Phasenströme ($i_1$, ... $i_n$) von Phasenstromsensoren ($S_1$, ..., $S_n$) erfasst werden, **dadurch gekennzeichnet, dass** eine Anzahl (m) Phasengruppen ($G_1$,..., $G_m$) vorgesehen ist, welche einen Teil der Phasen ($L_1$, ..., $L_n$) umfasst, wobei die Phasenströme ($i_1$, ... ,$i_n$) der Anzahl (m) Phasengruppen ($G_1$,..., $G_m$) in einem Gruppenknoten ($K_1$,... $K_m$) zu einem Gruppensummenstrom ($i_{g1}$,..., $i_{gm}$) zusammengeführt werden und ein Gruppensummenstrommesswert ($i_{Mg1}$, ..., $i_{Mgm}$) des Gruppensummenstroms von einem Gruppenstromsensor ($S_{g1}$,... , $S_{gm}$) erfasst wird, dass die, der Anzahl (m) Phasengruppen ($G_1$,..., $G_m$) zugehörigen, Strommesswerte ($i_{M1}$, ..., $i_{Mn}$) von einer Gruppensummiereinheit ($E_1$, $E_2$,..., $E_m$) zu einer Gruppensumme ($i_{G1}$, ..., $i_{Gm}$) summiert werden, und dass die Gruppensumme ($i_{G1}$, ..., $i_{Gm}$) mit dem Gruppensummenstrommesswert ($i_{Mg1}$, ..., $i_{Mgm}$) von einer Gruppenvergleichseinheit ($V_1$,..., $V_m$) verglichen wird um die Phasenströme ($i_1$,..., $i_n$) der Phasen ($L_1$, ..., $L_n$) zu validieren, um den sicheren Betrieb des Mehrphasensystems (1) sicherzustellen.

2. Verfahren nach Anspruch 1, wobei die Phasenströme ($i_1$,..., $i_n$) aller Phasen ($L_1$, ..., $L_n$) des Mehrphasensystems (1) auf eine Anzahl (m) Phasengruppen ($G_1$,..., $G_m$) aufgeteilt werden und in jeder Phasengruppe ($G_1$,..., $G_m$) jeweils die Phasenströme ($i_1$, ... ,$i_n$) der Phasengruppe ($G_1$,..., $G_m$) in einem Gruppenknoten zu einem Gruppensummenstrom ($i_{g1}$,..., $i_{gm}$) zusammengeführt werden und jeweils ein Gruppensummenstrommesswert ($i_{Mg1}$, ..., $i_{Mgm}$) des Gruppensummenstroms erfasst wird, wobei in jeder Phasengruppe ($G_1$,..., $G_m$) die Strommesswerte ($i_{M1}$, ..., $i_{Mn}$) der Phasenströme ($i_1$, ... $i_n$) jeweils von einer Gruppensummiereinheit ($E_1$, $E_2$,..., $E_m$) zu einer Gruppensumme ($i_{G1}$, ..., $i_{Gm}$) summiert werden wird, und wobei pro Phasengruppe ($G_1$,..., $G_m$) die Gruppensummen ($i_{G1}$, ..., $i_{Gm}$) jeweils von einer Gruppenvergleichseinheit ($V_1$,..., $V_m$) mit dem zugehörigen Gruppensummenstrommesswerten ($i_{Mg1}$, ..., $i_{Mgm}$) verglichen werden, um die Phasenströme ($i_1$,..., $i_n$) aller Phasen zu validieren.

3. Verfahren nach Anspruch 1 oder 2, wobei Anzahl (m) Phasengruppen ($G_1$,..., $G_m$) jeweils dieselbe Anzahl ($p_1$,..., $p_m$) an Phasen ($L_1$, ..., $L_n$) umfassen.

4. Verfahren nach einem der Ansprüche 1 bis 3, wobei die Strommesswerte ($i_{M1}$, ..., $i_{Mn}$) der Phasenströme ($i_1$, ... $i_n$) entsprechend einer vorgegebenen Sicherheitsanforderung sicher erfasst werden.

5. Verfahren nach einem der Ansprüche 1 bis 4, wobei bei einer fehlgeschlagenen Validierung von einer Aktionseinheit eine Aktion ausgelöst wird.

6. Verfahren nach Anspruch 5, wobei als Aktion ein optisches und/oder akustisches Signal ausgegeben wird und/oder zumindest ein Teil des Mehrphasensystems stillgelegt wird.

7. Mehrphasensystem (1) umfassend eine Mehrzahl (n) an Phasen ($L_1$, ..., $L_n$), wobei in den Phasen ($L_1$, ..., $L_n$) jeweils ein Phasenstrom ($i_1$, ... $i_n$) fließt, wobei Phasenstromsensoren ($S_1$, ..., Sn) zur Erfassung von Strommesswerten ($i_{M1}$, ..., $i_{Mn}$) der Phasenströme ($i_1$, ... $i_n$) vorgesehen sind, **dadurch gekennzeichnet, dass** eine Anzahl (m) Phasengruppen ($G_1$,..., $G_m$) vorgesehen ist, welche einen Teil ($p_1$, .. ,$p_m$) der Phasen ($L_1$, ..., $L_n$) umfasst, wobei ein Gruppenknoten vorgesehen ist, in welchem die Phasenströme ($i_1$, ... ,$i_n$) der Anzahl (m) Phasengruppen ($G_1$,..., $G_m$) zu einem Gruppensummenstrom ($i_{g1}$,..., $i_{gm}$) zusammengeführt sind, **dass** ein Gruppenstromsensor ($S_{g1}$,..., $S_{gm}$) zur Erfassung eines Gruppensummenstrommesswerts ($i_{Mg1}$, ..., $i_{Mgm}$) des Gruppensummenstroms vorgesehen ist, **dass** eine Gruppensummiereinheit ($E_1$, $E_2$,..., $E_m$) vorgesehen ist, die ausgestaltet ist die der Anzahl (m) Phasengruppen zugehörigen Strommesswerte ($i_{M1}$, ..., $i_{Mn}$) der Phasenströme ($i_1$, ... $i_n$) zu einer Gruppensumme ($i_{G1}$, ..., $i_{Gm}$) zu summieren, **und dass** eine Gruppenvergleichseinheit ($V_1$,..., $V_m$) vorgesehen ist, welche ausgestaltet ist die Gruppensumme ($i_{G1}$, ..., $i_{Gm}$) mit dem Gruppensummenstrommesswert ($i_{Mg1}$, ..., $i_{Mgm}$) zu vergleichen um die Phasenströme ($i_1$,..., $i_n$) der Phasen zu validieren, um den sicheren Betrieb des Mehrphasensystems (1) sicherzustellen.

8. Mehrphasensystem (1) nach Anspruch 7, wobei die Anzahl (m) Phasengruppen ($G_1$,..., $G_m$) alle Phasen ($L_1$, ..., $L_n$) des Mehrphasensystems (1) umfasst, wobei in jeder Phasengruppe ($G_1$,..., $G_m$) jeweils die Phasenströme ($i_1$, ... ,$i_n$) der Phasengruppe ($G_1$,..., $G_m$) in einem Gruppenknoten zu einem Gruppensummenstrom ($i_{g1}$,..., $i_{gm}$) zusammengeführt sind, wobei pro Phasengruppe ($G_1$,..., $G_m$) eine Gruppensummiereinheit ($E_1$, $E_2$,..., $E_m$) vorgehen ist, die jeweils ausgestaltet ist die Strommesswerte ($i_{M1}$, ..., $i_{Mn}$) der Phasenströme ($i_1$, ... $i_n$) zu einer Gruppensumme ($i_{G1}$, ..., $i_{Gm}$) zu summieren, und wobei pro Phasengruppe ($G_1$,..., $G_m$) eine Gruppenvergleichseinheit ($V_1$,..., $V_m$) vorgesehen ist, welche jeweils ausgestaltet ist die Gruppensummen ($i_{G1}$, ..., $i_{Gm}$) mit dem zugehörigen Gruppensummenstrommesswerten ($i_{Mg1}$, ... , $i_{Mgm}$) zu vergleichen, um die Phasenströme ($i_1$,..., $i_n$) aller Phasen ($L_1$, ..., $L_n$) zu validieren.

9. Mehrphasensystem (1) nach Anspruch 7 oder 8, wobei eine Aktionseinheit vorgesehen ist, die mit der Gruppenvergleichseinheit ($V_1$,..., $V_m$) verbunden ist und ausgestaltet ist bei einer fehlgeschlagenen Validierung eine Aktion auszulösen.

10. Mehrphasensystem (1) nach Anspruch 9, wobei die Aktionseinheit ausgestaltet ist ein optisches und/oder akustisches Signal auszugeben und/oder zumindest einen Teil des Mehrphasensystems stillzulegen.

## Claims

1. Method for safely operating a multi-phase system (1), wherein a phase current ($i_1$, ..., $i_n$) flows in each of a plurality (n) of phases ($L_1$, ..., $L_n$) of the multiphase system (1) respectively, and wherein current measurement values ($i_{M1}$, ..., $i_{Mn}$) of the phase currents ($i_1$,... $i_n$) are captured by phase current sensors ($S_1$, ..., $S_n$) in order to validate the phase currents ($i_1$, ..., $i_n$), **characterized in that** a number (m) of phase groups ($G_1$, ..., $G_m$) is provided, which comprises some of the phases ($L_1$, ..., $L_n$), wherein the phase currents ($i_1$, ..., $i_n$) of the number (m) of phase groups ($G_1$, ..., $G_m$) are merged in a group node ($K_1$,... $K_m$) to form a group sum current ($i_{g1}$, ..., $i_{gm}$), and a group sum current measurement value ($i_{Mg1}$, ..., $i_{Mgm}$) of the group sum current is captured by a group current sensor ($S_{g1}$, ..., $S_{gm}$), **in that** the current measurement values ($i_{M1}$, ..., $i_{Mn}$) belonging to the number (m) of phase groups ($G_1$, ..., $G_m$) are summed up by a group summation unit ($E_1$, $E_2$, ..., $E_m$) to form a group sum ($i_{G1}$, ..., $i_{Gm}$), **and in that** the group sum ($i_{G1}$, ..., $i_{Gm}$) is compared with the group sum current measurement value ($i_{Mg1}$, ..., $i_{Mgm}$) by a group comparison unit ($V_1$, ..., $V_m$) to validate the phase currents ($i_1$, ..., $i_n$) of the phases ($L_1$, ..., $L_n$) in order to ensure safe operation of the multi-phase system (1).

2. Method according to claim 1, **wherein** the phase currents ($i_1$, ..., $i_n$) of all the phases ($L_1$, ..., $L_n$) of the multi-phase system (1) are divided into a number (m) of phase groups ($G_1$, ..., $G_m$), and in each phase group ($G_1$, ..., $G_m$) the phase currents ($i_1$, ..., $i_n$) of the phase group ($G_1$, ..., $G_m$) are merged in a group node to form a group sum current ($i_{g1}$, ..., $i_{gm}$) and a group sum current measurement value ($i_{Mg1}$, ..., $i_{Mgm}$) of the group sum current is captured, **wherein,** in each phase group ($G_1$, ..., $G_m$), the current measurement values ($i_{M1}$, ..., $i_{Mn}$) of the phase currents ($i_1$, ... $i_n$) will each be summed up by a group summation unit ($E_1$, $E_2$, ..., $E_m$) to form a group sum ($i_{G1}$, ..., $i_{Gm}$), **and wherein,** for each phase group ($G_1$, ..., $G_m$), the group sums ($i_{G1}$, ..., $i_{Gm}$) are each compared with the associated group sum current measurement values ($i_{Mg1}$, ..., $i_{Mgm}$) by a group

comparison unit ($V_1$, ..., $V_m$) in order to validate the phase currents ($i_1$, ..., $i_n$) of all the phases.

3. Method according to either claim 1 or claim 2, **wherein** the number (m) of phase groups ($G_1$, ..., $G_m$) each comprises the same number ($p_1$, ..., $p_m$) of phases ($L_1$, ..., $L_n$).

4. Method according to any of claims 1 to 3, **wherein** the current measurement values ($i_{M1}$, ..., $i_{Mn}$) of the phase currents ($i_1$, ... $i_n$) are safely captured in accordance with a specified safety requirement.

5. Method according to any of claims 1 to 4, **wherein** an action is triggered by an action unit in the event of a failed validation.

6. Method according to claim 5, **wherein** an optical and/or acoustic signal is output as the action and/or at least a part of the multi-phase system is shut down.

7. Multi-phase system (1) comprising a plurality (n) of phases ($L_1$, ..., $L_n$), wherein a phase current ($i_1$, ... $i_n$) flows in each of the phases ($L_1$, ..., $L_n$), wherein phase current sensors ($S_1$, ..., $S_n$) are provided for capturing current measurement values ($i_{M1}$, ..., $i_{Mn}$) of the phase currents ($i_1$, ... $i_n$), **characterized in that** a number (m) of phase groups ($G_1$, ..., $G_m$) is provided, which comprises some ($p_1$, .., $p_m$) of the phases ($L_1$, ..., $L_n$), wherein a group node is provided, within which the phase currents ($i_1$, ..., $i_n$) of the number (m) of phase groups ($G_1$, ..., $G_m$) are merged to form a group sum current ($i_{g1}$, ..., $i_{gm}$), **in that** a group current sensor ($S_{g1}$, ..., $S_{gm}$) is provided for capturing a group sum current measurement value ($i_{Mg1}$, ..., $i_{Mgm}$) of the group sum current, **in that** a group summation unit ($E_1$, $E_2$, ..., $E_m$) is provided, which is designed to sum up the current measurement values ($i_{M1}$, ..., $i_{Mn}$) of the phase currents ($i_1$, ... $i_n$) belonging to the number (m) of phase groups to form a group sum ($i_{G1}$, ..., $i_{Gm}$), **and in that** a group comparison unit ($V_1$, ..., $V_m$) is provided, which is designed to compare the group sum ($i_{G1}$, ..., $i_{Gm}$) with the group sum current measurement value ($i_{Mg1}$, ..., $i_{Mgm}$) to validate the phase currents ($i_1$, ..., $i_n$) of the phases in order to ensure safe operation of the multi-phase system (1).

8. Multi-phase system (1) according to claim 7, **wherein** the number (m) of phase groups ($G_1$, ..., $G_m$) comprises all the phases ($L_1$, ..., $L_n$) of the multi-phase system (1), wherein the phase currents ($i_1$, ..., $i_n$) of the phase group ($G_1$, ..., $G_m$) are merged in a group node to form a group sum current ($i_{g1}$, ..., $i_{gm}$) in each phase group ($G_1$, ..., $G_m$), **wherein** a group summation unit ($E_1$, $E_2$, ..., $E_m$) is provided for each phase group ($G_1$, ..., $G_m$), which is designed to sum up the current measurement values ($i_{M1}$, ..., $i_{Mn}$) of the phase currents ($i_1$, ... $i_n$) to form a group sum ($i_{G1}$, ..., $i_{Gm}$) respectively, **and wherein** a group comparison unit ($V_1$, ..., $V_m$) is provided for each phase group ($G_1$, ..., $G_m$), which is designed to compare the group sums ($i_{G1}$, ..., $i_{Gm}$) with the associated group sum current measurement values ($i_{Mg1}$, ..., $i_{Mgm}$) respectively in order to validate the phase currents ($i_1$, ..., $i_n$) of all the phases ($L_1$, ..., $L_n$).

9. Multi-phase system (1) according to either claim 7 or claim 8, **wherein** an action unit is provided, which is connected to the group comparison unit ($V_1$, ..., $V_m$) and is designed to trigger an action in the event of a failed validation.

10. Multi-phase system (1) according to claim 9, **wherein** the action unit is designed to output an optical and/or acoustic signal and/or to shut down at least part of the multi-phase system.

**Revendications**

1. Procédé de fonctionnement sûr d'un système polyphasé (1), dans lequel respectivement un courant de phase ($i_1$, ..., $i_n$) circule dans une pluralité (n) de phases ($L_1$, ..., $L_n$) du système polyphasé (1) et dans lequel des valeurs de mesure de courant ($i_{M1}$, $i_{Mn}$) des courants de phase ($i_1$, ..., $i_n$) sont détectées par des capteurs de courant de phase ($S_1$, ..., $S_n$) pour une validation des courants de phase ($i_1$, ..., $i_n$), **caractérisé en ce qu'**un nombre (m) de groupes de phases ($G_1$, ..., $G_m$) est fourni, lequel comprend une partie des phases ($L_1$, ..., $L_n$), dans lequel les courants de phase ($i_1$, ..., $i_n$) du nombre (m) de groupes de phases ($G_1$, ..., $G_m$) sont combinés dans un nœud de groupes ($K_i$, ..., $K_m$) pour former un courant de sommes de groupes ($i_{g1}$, ..., $i_{gm}$) et une valeur de mesure de courant de sommes de groupes ($i_{Mg1}$, ..., $i_{Mgm}$) du courant de sommes de groupes est détectée par un capteur de courant de groupes ($S_{g1}$, ..., $S_{gm}$), **que** les valeurs de mesure de courant ($i_{M1}$, ..., $i_{Mn}$) associées au nombre (m) de groupes de phases ($G_1$, ..., $G_m$) sont additionnées par une unité d'addition de groupes ($E_1$, $E_2$, ..., $E_m$) pour former une somme de groupes ($i_{G1}$, ..., $i_{Gm}$), **et que** la somme de groupes ($i_{G1}$, ..., $i_{Gm}$) est comparée à la valeur de mesure de courant de sommes de groupes ($i_{Mg1}$, ..., $i_{Mgm}$) par une unité de comparaison de groupes ($V_1$, ..., $V_m$) pour valider les courants de phase ($i_1$, ..., $i_n$) des phases ($L_i$, ..., $L_n$) pour assurer le fonctionnement sûr du système polyphasé (1).

2. Procédé selon la revendication 1, dans lequel les courants de phase ($i_1$, ..., $i_n$) de toutes les phases ($L_1$, ..., $L_n$) du système polyphasé (1) sont divisés en un nombre (m) de groupes de phases ($G_1$, ..., $G_m$) et, dans chaque groupe de phases ($G_1$, ..., $G_m$), les

courants de phase ($i_1$, ..., $i_n$) du groupe de phases ($G_1$, ..., $G_m$) sont respectivement combinés dans un nœud de groupes pour former un courant de sommes de groupe ($i_{g1}$, ..., $i_{gm}$) et une valeur de mesure de courant de sommes de groupe ($i_{mg1}$, ..., $i_{Mgm}$) du courant de sommes du groupe est respectivement enregistrée, dans lequel les valeurs de mesure de courant ($i_{M1}$, ..., $i_{Mn}$) des courants de phase ($i_1$, ..., in) sont respectivement additionnées par une unité d'addition de groupes ($E_1$, $E_2$, ..., $E_m$) pour former une somme de groupes ($i_{G1}$, ..., $i_{Gm}$), et dans lequel, pour chaque groupe de phases ($G_1$, ..., $G_m$), les sommes de groupes ($i_{G1}$, ..., $i_{Gm}$) sont respectivement comparées aux valeurs de mesure de courant de sommes de groupes ($i_{Mg1}$, ..., $i_{Mgm}$) associées par une unité de comparaison de groupes ($V_1$, ..., $V_m$), pour valider les courants de phase ($i_1$, ..., $i_n$) de toutes les phases.

3. Procédé selon la revendication 1 ou 2, dans lequel le nombre (m) de groupes de phases ($G_1$, ..., $G_m$) comprennent respectivement le même nombre ($p_1$, ..., $p_m$) de phases ($L_1$, ..., $L_n$).

4. Procédé selon l'une quelconque des revendications 1 à 3, dans lequel les valeurs de mesure de courant ($i_{M1}$, ..., $i_{Mn}$) des courants de phase ($i_1$, ..., $i_n$) sont enregistrées de manière sûre selon une exigence de sécurité prédéfinie.

5. Procédé selon l'une quelconque des revendications 1 à 4, dans lequel une action est déclenchée par une unité d'action en cas d'échec de validation.

6. Procédé selon la revendication 5, dans lequel un signal optique et/ou acoustique est émis en tant qu'action et/ou au moins une partie du système polyphasé est arrêtée.

7. Système polyphasé (1) comprenant une pluralité (n) de phases ($L_1$, ..., $L_n$), dans lequel respectivement un courant de phase ($i_1$, ..., $i_n$) circule dans les phases ($L_1$, ..., $L_n$), dans lequel des capteurs de courant de phase ($S_1$, ..., $S_n$) sont fournis pour détecter des valeurs de mesure de courant ($i_{M1}$, ..., $i_{Mn}$) des courants de phase ($i_1$, ..., in), **caractérisé en ce qu'**un nombre (m) de groupes de phases ($G_1$, ..., $G_m$) est fourni, lequel comprend une partie ($p_1$, ..., $p_m$) des phases ($L_1$, ..., $L_n$), dans lequel un nœud de groupes est fourni, dans lequel les courants de phase ($i_1$, ..., $i_n$) du nombre (m) de groupes de phases ($G_1$, ..., $G_m$) sont combinés pour former un courant de sommes de groupes ($i_{g1}$, ..., $i_{gm}$), **qu'**un capteur de courant de groupes ($S_{g1}$, ..., $S_{gm}$) est fourni pour détecter une valeur de mesure de courant de sommes de groupe ($i_{Mg1}$, ..., $i_{Mgm}$) du courant de sommes de groupe, **qu'**une unité d'addition de groupes ($E_1$, $E_2$, ..., $E_m$) est fournie, laquelle est conçue pour additionner les valeurs de mesure de courant ($i_{M1}$, ..., $i_{Mn}$) des courants de phase ($i_1$, ..., $i_n$) associées au nombre (m) de groupes de phase pour former une somme de groupes ($i_{g1}$, ..., $i_{Gm}$) **et qu'**une unité de comparaison de groupes ($V_1$, ..., $V_m$) est fournie, laquelle est conçue pour comparer la somme de groupes ($i_{G1}$, ..., $i_{Gm}$) à la somme de mesure de courant de sommes de groupes ($i_{mg1}$, ..., $i_{Mgm}$) pour valider les courants de phase ($i_1$, ..., $i_n$) des phases pour assurer le fonctionnement sûr du système polyphasé (1).

8. Système polyphasé (1) selon la revendication 7, dans lequel le nombre (m) de groupes de phases ($G_1$, ..., $G_m$) comprend toutes les phases ($L_1$, ..., $L_n$) du système polyphasé (1), dans lequel dans chaque groupe de phase ($G_1$, ..., $G_m$), les courants de phase ($i_1$, ..., $i_n$) du groupe de phases ($G_1$, ..., $G_m$) sont respectivement combinés dans un nœud de groupes pour former un courant de sommes de groupes ($i_{g1}$, ..., $i_{gm}$), dans lequel une unité d'addition de groupes ($E_1$, $E_2$, ..., $E_m$) est fournie par groupe de phases ($G_1$, ..., $G_m$), laquelle est respectivement conçue pour additionner les valeurs de mesure de courant ($i_{m1}$, ..., $i_{Mn}$) des courants de phase ($i_1$, ..., $i_n$) pour former une somme de groupes ($i_{G1}$, ..., $i_{Gm}$), et dans lequel une unité de comparaison de groupes ($V_1$, ..., $V_m$) est fournie par groupe de phases ($G_1$, ..., $G_m$), laquelle est respectivement conçue pour comparer les sommes de groupe ($i_{G1}$, ..., $i_{Gm}$) aux valeurs de mesure de courant de sommes de groupes ($i_{Mg1}$, ..., $i_{Mgm}$) associées pour valider les courants de phase ($i_1$, ..., $i_n$) de toutes les phases ($L_1$, ..., $L_n$).

9. Système polyphasé (1) selon la revendication 7 ou 8, dans lequel une unité d'action est fournie, laquelle est connectée à l'unité de comparaison de groupes ($V_1$, ..., $V_m$) et est conçue pour déclencher une action en cas d'échec de validation.

10. Système polyphasé (1) selon la revendication 9, dans lequel l'unité d'action est conçue pour émettre un signal optique et/ou acoustique et/ou pour arrêter au moins une partie du système polyphasé.

Fig. 1
(Stand der Technik)

$i_g = i_1 + i_2 + \ldots\ldots i_n$

$i_{Mg} = i_g + \varepsilon_g$

$i_{M1} = i_1 + \varepsilon_1$
$i_{M2} = i_2 + \varepsilon_2$
$i_{M3} = i_3 + \varepsilon_3$
$i_{M4} = i_4 + \varepsilon_4$
$i_{M5} = i_5 + \varepsilon_5$
$i_{M6} = i_6 + \varepsilon_6$
$i_{Mn-2} = i_{n-2} + \varepsilon_{n-2}$
$i_{Mn-1} = i_{n-1} + \varepsilon_{n-1}$
$i_{Mn} = i_n + \varepsilon_n$

$i_M = i_{M1} + i_{M2} \ldots i_n$
$= \sum_{j=1}^{n} i_{Mj}$
$= \sum_{j=1}^{n} i_j + \sum_{j=1}^{n} \varepsilon_j$

$i_M \overset{\varepsilon V}{\Longrightarrow} i_{Mg}$
$\varepsilon V = \sum_{j=1}^{n} \varepsilon_j + \varepsilon_g$

E0

V0

11

Fig. 2 (Teil 1)

Fig. 2 (Teil 2)

Em

$i_{Gm} = i_{Mn-2} + i_{Mn-1} + i_n$

$= i_{n-2} + i_{n-1} + i_n + \varepsilon_{n-2} + \varepsilon_{n-1} + \varepsilon_n$

$i_{Mn-2} = i_{n-2} + \varepsilon_{n-2}$

$i_{Mn-1} = i_{n-1} + \varepsilon_{n-1}$

$i_{Mn} = i_n + \varepsilon_n$

$S_{n-2}$

$S_{n-1}$

$S_n$

$i_{Gm}$

Vm

$\varepsilon_{VGm.}$
$i_{Mgm} \Longleftrightarrow i_{Gm}$

$i_{Mgm} = i_{gm} + \varepsilon_{gm}$

$K_m$

$S_{gm}$

$\varepsilon_{VGm} = \varepsilon_{n-2} + \varepsilon_{n-1} + \varepsilon_n + \varepsilon_{gm}$

A

$K_g$

$i_g = i_1 + i_2 + \ldots\ldots i_n$

$i_{gm} = i_{n-2} + i_{n-1} + i_n$

EP 3 828 564 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3109999 A2
- US 2018358888 A1
- US 5357181 A
- US 2014266111 A1
- US 6005393 A